Europäisches Patentamt

(19) European Patent Office    (11) Publication number: **0 127 295**
Office européen des brevets                 **B1**

(12)    **EUROPEAN PATENT SPECIFICATION**

(45) Date of publication of patent specification: **29.07.87**    (51) Int. Cl.⁴: **G 01 R 1/073**

(21) Application number: **84302479.5**

(22) Date of filing: **11.04.84**

(54) **Test probe assembly for IC chips.**

(30) Priority: **03.05.83 US 491233**

(43) Date of publication of application:
**05.12.84 Bulletin 84/49**

(45) Publication of the grant of the patent:
**29.07.87 Bulletin 87/31**

(84) Designated Contracting States:
**CH DE FR GB IT LI NL SE**

(56) References cited:
**DE-B-1 910 314**
**US-A-3 835 381**
**US-A-3 891 924**
**US-A-3 905 098**
**US-A-4 161 692**

(73) Proprietor: **WENTWORTH LABORATORIES, INC.**
**500 Federal Road**
**Brookfield Connecticut 06804-2098 (US)**

(72) Inventor: **Evans, Arthur**
**Sunset Hill Road**
**Brookfield Center Connecticut 06805 (US)**

(74) Representative: **Wright, Peter David John et al**
**R.G.C. Jenkins & Co. 12-15, Fetter Lane**
**London EC4A 1PL (GB)**

Courier Press, Leamington Spa, England.

## Description

This invention relates generally to the testing of integrated circuit chips, and, more particularly to a microelectronic test probe assembly for this purpose.

Many circuits and complex multi-stage electronic systems, previously regarded as economically unfeasible and impractical, are now realizable in integrated circuit form. The fabrication of a single-crystal monolithic circuit involves the formation of diodes, transistors, resistors and capacitors on a single microelectronic substrate. In practice, a microelectronic substrate for semiconductor integrated circuits is sealed on a silicon wafer, the circuit patterns being applied to the wafer by photolithography. Each wafer contains the patterns of many identical integrated circuits, the wafer being sliced into "dice", each die or chip containing a single integrated circuit.

In a typical integrated circuit (IC) chip, the input, output, power supply and other terminals of the circuit are formed by metallized contacts, usually deployed along the margins of the circuit pattern. The outline of the chip is either square or rectangular, and the marginal locations of the contacts thereon depend on the circuit configuration and the available marginal space. In some instances, therefore, the contacts may lie in uniform rows along the margins, and in other cases, the contacts may be randomly spaced from each other.

For the purpose of testing any type of integrated-circuit patterns, before the application thereto of leads to connect the contacts to other components, various types of test probe cards have been developed. In one well known form, the probe card consists of a printed circuit board having an opening or port therein to provide access to an IC pattern. This opening is surrounded by a circle of conductive pads connected by the traces of the printed circuit to terminals on the card which, in turn, are connected to test equipment appropriate to the circuit. The number of pads in the circle determine the maximum capacity of the probe card. If, for example, the card has forty-eight pads, it is capable of testing IC patterns having forty-eight contacts or less.

In setting up a probe card for a particular IC chip pattern, probes constituted by needles of tungsten are affixed to selected pads, the needles extending across the opening. The length and orientation of each needle is such that its point is adapted to engage a respective contact on the IC pattern.

To assemble a probe card for this pattern, one must attach needles to those pads which are most conveniently located with respect to the contacts on the chip. The stretch of each needle depends on the distance between its pad and the particular contact to be engaged. Hence the needles in a conventional probe card vary in length.

Since all of the contacts in the IC pattern lie in a common plane, and must be simultaneously engaged in order to carry out testing, it is essential that all needle points lie in a plane parallel to the common IC plane. Consequently, a fundamental requirement of a probe card is planarization of the needle points. The nature of conventional probe cards and the character of the assembly fixtures for setting up the probe positions for such cards are such that it is virtually impossible to assemble probes with needle points lying exactly in the same plane.

With a view to providing an improved microelectronic test probe card, the *Garretson et al.* U.S. patents 3,835,381 and 3,905,098 disclose a structure in which needle-like probes formed of tungsten wire are supported on the tapered face of a dielectric base ring surrounding a circular opening in the card, the wires being in a generally conical array with respect to the opening. A layer of dielectric material adherent to the tapered surface of the ring acts to secure the wires thereto, the wires being embedded in the layer. The outer ends of the wires are connected to terminals on the card, whereas the inner ends leading to the apex of the cone are bent down to form tips which engage the respective contacts on the IC chip to be tested.

Because the tips of the needles must all lie in a common plane, the angles of the needles in the conical array thereof must be adjusted relative to the tapered surface of the ring to engage the respective contacts on the chip. Thus a steeper angle is required to reach a contact, say, at the corner of the rectangular chip than a contact displaced from a corner. To this end, feeler gauges are used by *Garretson et al.* to control the positions and locations of each needle on the tapered face of the ring.

After the needles have been carefully adjusted to assume their proper angles, an epoxy or other dielectric material is superimposed over the array of needle probes so as to embed the probes at their assigned angle and position in the epoxy. The assembly so arranged is then heated to cause hardening if the epoxy to thereby retain the array of needles at their selected sites.

In practice, it is a relatively difficult matter to construct a test probe card of the Garretson et al. type; for to create the necessary conical array of needles, one must use a jig having a conical configuration; and because the needles must be positioned at various angles relative to the conical surface of the jig, the needles make point contact with the jig only at the back end thereof and tend to fall out of position. Also, it is difficult to set the needles relative to the jig to allow proper clearance therebetween for epoxy flow.

A further disadvantage is that because the needles are at different angles, the scrub characteristics of the needles are not uniform. Moreover, as needles are added to the jig, it is impossible to control the final angle of each needle, as all needles in the jig have slightly different angles due to the cone effect.

According to the present invention there is provided a test probe assembly for testing an integrated circuit chip before leads are applied to the contacts thereof which are dispersed on said chip in a common plane, said assembly comprising:

a planar insulation card provided with a port and having a printed circuit thereon whose traces are connected to a plurality of test terminals connectable to test equipment for testing the chip;

a mounting ring of uniform thickness formed of dielectric material surrounding said port and secured to said card at the underside thereof, said ring having a planar face parallel to the plane of the card; and

a radial array of fine wires supported on the planar face of the ring and maintained in planar position thereon by a moulded layer of dielectric material adherent to said face, the wires being embedded in said layer, the wires being cantilevered from the ring across the port and converging toward the central region thereof, below which in use of the assembly is disposed the chip to be tested, the leading ends of the cantilevered wires being double-bent to define a knee in each wire having an obtuse angle (∅) and a needle tip, the tips of the needles being coplanar and respectively engaging the contacts on the chip in use of the assembly, the obtuse angle (∅) being uniform through the array, and the trailing ends of the wires which diverge outwardly from the ring being connected to the traces, whereby each needle tip is connected to a respective test terminal.

Among the advantages of a probe test assembly in accordance with the invention over a prior art assembly in which the wires lie in a conical array is that the angle between each needle and the surface of the chip or other microelectronic device under test is uniform. As a consequence, all needle tips in this array thereof may be identically viewed under a microscope, thereby facilitating alignment and placement of the probe card when in use for electrical testing and measurement.

Also characteristic of a test probe assembly in accordance with the invention is the uniform and consistent scrubbing of the needle point of contact against the microelectronic device under test.

Yet another advantage of the invention is that the radial array of wires of the test probe assembly lies in a horizontal plane, thereby obviating the need for feeler gauges to locate and orient the wires on a probe ring fixture, as in prior art arrangements.

The invention furthermore provides an efficient and reliable test probe assembly which may be fabricated without difficulty and manufactured at relatively low cost.

Other features of the invention are set forth with particularity in the appended claims and will be well understood by consideration of the following detailed description to be read in conjunction with the accompanying drawings, wherein:

Fig. 1 is a bottom plan view of a preferred embodiment of a test probe assembly in accordance with the invention;

Fig. 2 is a top plan view of the assembly;

Fig. 3 separately illustrates in section, the mounting ring on the card and a single probe supported thereby;

Fig. 4 is a perspective view illustrating the relationship of the test probe assembly to an IC chip to be tested thereby;

Fig. 5 is an enlarged view of the chip being tested, with the needles of the assembly in engagement with the contacts of the chip;

Fig. 6 is a section taken in the plane indicated by line 6—6 in Fig. 5; and

Fig. 7 is a sectional view of the jig for setting up the array of probe wires to be supported on the ring.

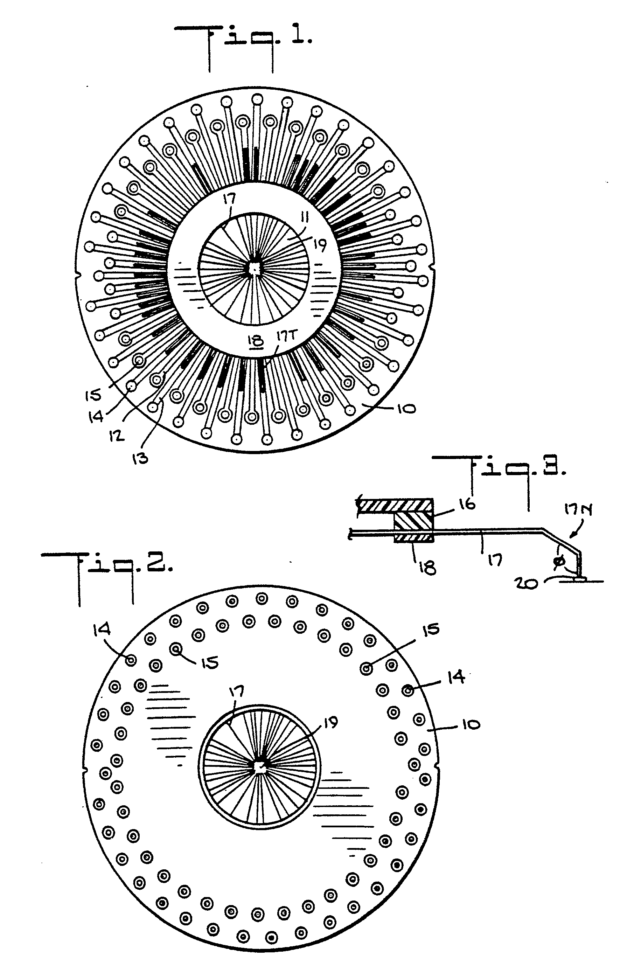

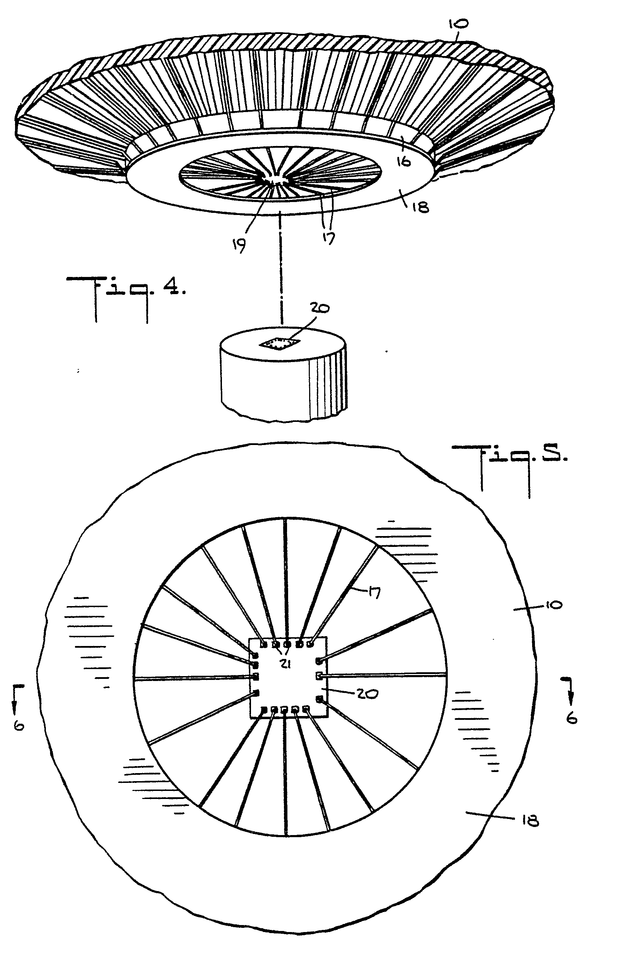

Referring now to Figs. 1 and 2, there is illustrated a preferred embodiment of a test probe assembly in accordance with the invention for checking an integrated circuit chip before leads are connected to the contacts of the chip. The function of the test probe assembly is to engage the chip contacts and connect them to test terminals which in turn are connected to external test equipment so that the chip circuits may be fully tested to be sure that it satisfies the specifications therefor before the chip is permanently connected to its associated components.

The assembly includes a planar printed circuit board or card 10 fabricated of synthetic plastic or other insulating material which is structurally stable and of adequate strength. Card 10, which in the embodiment illustrated is circular in form, is provided with a circular central opening or port 11 to provide access to the chip to be tested. In practice, the planar card may be rectangular or in any other suitable configuration; and the port rather than being circular, may be oblong or in any other geometrical form.

Formed on one face of card 10 by printed circuit techniques are two sets 12 and 13 of radial traces which are interleaved. Traces 13 are connected to test terminals 14 in an outer circular series thereof adjacent the periphery of the card. Traces 12, which are somewhat shorter than traces 13, are connected to test terminals 15 in an inner circular series thereof concentric with the outer series. The advantage of this interleaved arrangement of radial traces is that it makes possible a high density of test terminals in a relatively small area.

Each test terminal on the card takes the form of a metal grommet inserted in a card hole and adapted to receive a plug-in pin 16, as shown in Fig. 6, whereby the assembly can be plugged into a test equipment socket rather than being wires thereto terminal by terminal. In practice, the grommets, instead of being discrete elements, may be formed by plating the hole surfaces. Also, the terminals may take the form of edge contacts plated on the surface of the card.

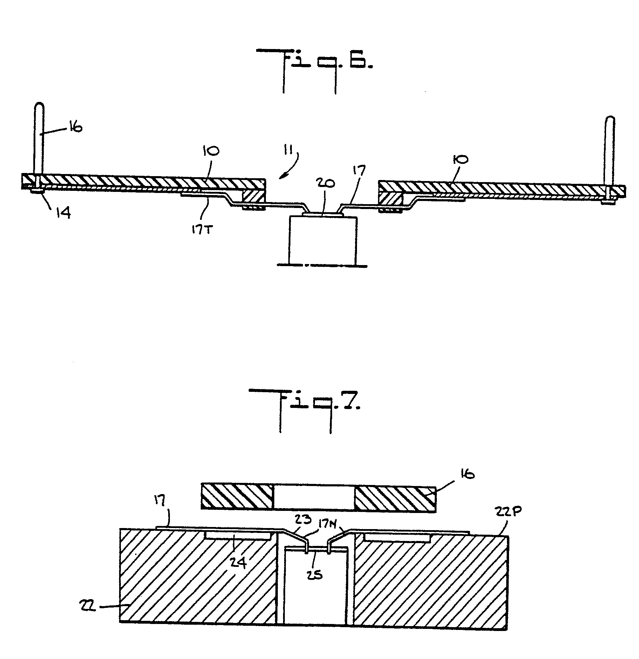

Surrounding port 11 and secured to the card, as shown in Figs. 3 and 4, is a mounting ring 16 which may be formed of ceramic, anodized aluminium or other dielectric material. The ring thus has a flat face parallel to the plane of the card for supporting at a raised position a radial array of fine wires 17, preferably made of tungsten. These wires are maintained in their assigned positions by a layer 18 of dielectric material which is adhered to the face of the ring, the wires being embedded therein. In practice, the layer may be molded of epoxy resin.

Wires 17 cantilever across port 11 and converge toward the central region 19 thereof, as shown in Fig. 4, just below which is the integrated circuit chip 20 to be tested. Chip 20, as shown in Fig. 5, has contacts 21 deployed thereon, all lying in a common horizontal plane, the contacts being located adjacent the margins of the chip.

As best seen in Fig. 3, the leading end of each wire is double bent to define an obtuse angle needle 17N. The knee angle φ is such that the tip of the needle which engages a contact on the chip, is at right angles to wire 17, this angle being uniform throughout the array. All needle tips in the array can therefore be viewed identically under the microscope. This improves alignment and placement of the finished test probe assembly when in use for electrical test and measurement. In practice, angle φ need not be a right angle.

The trailing ends 17T of wires 17 which diverge outwardly from the ring, as shown in Fig. 1, soldered to individual traces on the printed circuit, so that each needle is connected to a respective test terminal 14 or 15 in the inner and outer series thereof.

The number of wires 17 in the array and their placement is determined by the number of contacts 21 and their placement on the integrated circuit chip 20 to be tested. Thus, in the chip illustrated in Fig. 5, there are a relatively small number of contacts 21 deployed on chip 20; hence an equally small number of wires are required in the radial array, the placement of the wires being determined by the placement of these contacts. In practice, a much greater number of contacts and wires may be involved.

Referring now to Fig. 7, there is shown a jig 22 for fabricating a sub-assembly in accordance with the invention, the sub-assembly being in the form of a spider-like structure in which a radial array of needles are supported on mounting ring 16 and maintained at their assigned positions by a layer 18 of epoxy material adherent to the face of the ring, the wires being embedded therein.

Jig 22 is provided with a planar face 22 and a central circular bore 23. An annular channel 24 is formed in the jig concentric with bore 23 to receive the flow of the moldable, resinous dielectric material.

Tungsten wires 17 are laid down on planar face 22P to create the desired radial array, the obtuse angle needles 17N lying with the opening, with the needle tip being received in the separate apertures of a patterned mask 25. This mask is preferably formed of a thin sheet of "Mylar" in a selected pattern determined by the contact position of the chip to be tested. Channel 24 is of uniform depth to form the desired thickness of the adhered layer 18. These wires may be of tungsten, beryllium-copper or other suitable metal alloys.

After the wires are properly set up on the jig, ring 16, whose underside is coated with epoxy, is brought down on the array and clamped to the jig in a fixture. This fixture is then placed in an oven and heated to a temperature of about 200°F for a period, such as one hour, sufficient to effect curing and hardening of the resinous layer of dielectric epoxy in which the wires are embedded.

The resultant spider sub-assembly is removed from the mixture, the ring is bonded to the card around the port therein, and finally the trailing ends of the wires are soldered to the traces of the printed circuit.

## Claims

1. A test probe assembly for testing an integrated circuit chip (20) before leads are applied to the contacts thereof which are dispersed on said chip in a common plane, said assembly comprising:

a planar insulation card (10) provided with a port (11) and having a printed circuit thereon whose traces (12, 13) are connected to a plurality of test terminals (14, 15) connectable to test equipment for testing the chip;

a mounting ring (16) of uniform thickness formed of dielectric material surrounding said port (11) and secured to said card (10) at the underside thereof, said ring (16) having a planar face parallel to the plane of the card (10); and

a radial array of fine wires (17) supported on the planar face of the ring (16) and maintained in planar position thereon by a moulded layer (18) of dielectric material adherent to said face, the wires (17) being embedded in said layer (18), the wires (17) being cantilevered from the ring (16) across the port (11) and converging toward the central region (19) thereof, below which in use of the assembly is disposed the chip (20) to be tested, the leading ends of the cantilevered wires (17) being double-bent to define a knee in each wire (17) having an obtuse angle (φ) and a needle tip (17N), the tips of the needles being coplanar and respectively engaging the contacts on the chip (20) in use of the assembly, the obtuse angle (φ) being uniform through the array, and the trailing ends (17T) of the wires (17) which diverge outwardly from the ring (16) being connected to the traces (12, 13), whereby each needle tip (17N) is connected to a respective test terminal (14, 15).

2. An assembly as set forth in claim 1, wherein said card (10) is formed of synthetic plastic material.

3. An assembly as set forth in claim 1 or 2, wherein said card (10) has a circular form and said terminals (14, 15) are disposed in a circular series adjacent the periphery of the card.

4. An assembly as set forth in any preceding claim, wherein said port (11) is circular and at the center of the card (10).

5. An assembly as set forth in any preceding claim wherein said wires (17) are formed of tungsten.

6. An assembly as set forth in any of claims 1 to 4, wherein said wires (17) are formed of a copper alloy.

7. An assembly as set forth in any preceding claim, wherein said layer (18) is molded of epoxy resin.

8. An assembly as set forth in any preceding claim, wherein said ring (16) is formed of anodized aluminium.

9. An assembly as set forth in any of claims 1 to 7, wherein said ring (16) is formed of ceramic material.

**Patentansprüche**

1. Meßsonden-Anordnung zum Testen eines integrierten Schaltungschips (20), an den noch keine Drähte an seine Kontakte angeschlossen sind, welche auf dem Chip in einer gemeinsamen Ebene verteilt sind, gekennzeichnet durch

eine ebene Isolierkarte (10), die eine Öffnung (11) aufweist und auf der sich eine gedruckte Schaltung befindet, deren Leiterbahnen (12, 13) an eine Vielzahl von Test-Anschlüssen (14, 15) angeschlossen wind, welche mit einer Testeinrichtung zum Testen des Chips verbindbar sind;

einen Befestigungsring (16) gleichförmiger Dicke, der aus einem dielektrischen Material gebildet ist, die Öffnung (11) umgibt, an der Unterseite der Karte (10) befestigt ist und eine ebene Fläche aufweist, die parallel zu der Ebene der Karte (10) verläuft; sowie durch

eine radiale Anordnung dünner Drähte (17), die an der ebenen Fläche des Rings (16) abgestützt sind und mittels einer vergossenen Schicht (18) aus dielektrischem Material, die an der Fläche anhaftet, in ebener Lage darauf festgehalten sind, wobei die Drähte (17) in der Schicht (18) eingebettet sind, wobei sich die Drähte (17) freischwebend aus dem Ring (16) über die Öffnung (11) erstrekken und zu deren Mittelbereich (19) hin zusammenlaufen, unter dem sich während des Gebrauchs der Anordnung der zu testende Chip (20) befindet, wobei die vorderen Enden der freischwebenden Drähte (17) derart zweifach gebogen sind, daß in jedem Draht (17) in Knick mit einem stumpfen Winkel (φ) sowie eine Nadelspitze (17N) gebildet wird, wobei die Spitzen der Nadeln koplanar sind und während des Gebrauchs der Anordnung jeweils die Kontakte auf dem Chip (20) berühren, wobei der stumpfe Winkel (φ) innerhalb der Anordnung gleich ist, und wobei schließlich die hinteren Enden (17T) der Drähte (17), die zur Außenseite des Rings (16) hin auseinanderlaufen, mit den Leiterbahnen (12, 13) derart verbunden sind, daß jede Nadelspitze (17N) mit einem jeweiligen Testanschluß (14, 15) verbunden ist.

2. Anordnung nach Anspruch 1, dadurch gekennzeichnet, daß die Karte (10) aus synthetischem Plastikmaterial geformt ist.

3. Anordnung nach Anspruch 1 oder 2, dadurch gekennzeichnet, daß die Karte (10) kreisförmig ist und daß die Anschlüsse (14, 15) in der Nähe des Außenumfangs der Karte in einer kreisförmigen Reihe angeordnet sind.

4. Anordnung nach einem der vorangehenden Ansprüche, dadurch gekennzeichnet, daß die Öffnung (11) ringförmig ist und sich im Zentrum der Karte (10) befindet.

5. Anordnung nach einem der vorangehenden Ansprüche, dadurch gekennzeichnet, daß die Drähte (17) aus Wolfram bestehen.

6. Anordnung nach einem der Ansprüche 1 bis 4, dadurch gekennzeichnet, daß die Drähte (17) aus einer Kupferlegierung bestehen.

7. Anordnung nach einem der vorangehenden Ansprüche, dadurch gekennzeichnet, daß die Schicht (18) aus Epoxidharz gegossen ist.

8. Anordnung nach einem der vorangehenden Ansprüche, dadurch gekennzeichnet, daß der Ring (16) aus eloxiertem Aluminium besteht.

9. Anordnung nach einem der Ansprüche 1 bis 7, dadurch gekennzeichnet, daß der Ring (16) aus Keramikmaterial besteht.

**Revendications**

1. Ensemble formant sonde d'essai pour tester une microplaquette à circuits intégrés (20) avant que des conducteurs soient appliqués sur les contacts de cette dernière qui sont répartis sur ladite microplaquette dans un plan commun, ledit ensemble comprenant:

—une carte isolante plane (10) munie d'un orifice (11) et portant un circuit imprimé dont les pistes conductrices (12, 13) sont raccordées à une série de bornes d'essai (14, 15) pouvant être connectées à un appareillage d'essai servant à tester la microplaquette;

—un anneau de montage (16) possédant une épaisseur uniforme, réalisé en un matériau diélectrique, entourant ledit orifice (11) et fixé à ladite carte (10), sur la face inférieure de cette dernière, ledit anneau (16) présentant une face plane parallèle au plan de la carte (10); et

—un réseau de fils fins radiaux (17) porté par la face plane de l'anneau (16) et maintenu dans une position à plat sur celle-ci, au moyen d'une couche moulée (18) de matériau diélectrique adhérant à ladite face, les fils (17) étant noyés dans ladite couche (18) et étant montés en porteà-faux sur l'anneau (16) pour se prolonger à travers l'orifice (11) en convergeant vers la partie centrale (19) de ce dernier, au-dessous de laquelle est disposée, lors de l'utilisation de l'ensemble, la microplaquette (20) devant être testée, les extrémités ayant des fils (17) en porte-à-faux étant doublement pliées afin de définir, sur chaque fil (17), un coude formant un angle obtus (φ) et une pointe d'aiguille (17N), les pointes des aiguilles étant coplanaires et en contact respectivement avec les contacts situés sur la microplaquette (20) lors de l'utilisation de l'ensemble, l'angle obtus (φ) étant uniform sur la totalité du réseau, et les extrémités arrière (17T) des fils (17), qui divergent vers l'extérieur à partir de l'anneau (16), étant raccordées aux pistes conductrices (12, 13), auquel cas chaque pointe d'aiguille (17N) est raccordée à une borne d'essai respective (14, 15).

2. Ensemble selon la revendication 1, dans lequel ladite carte (10) est réalisée en une matière plastique synthétique.

3. Ensemble selon la revendication 1 ou 2, dans lequel ladite carte (10) possède une forme circulaire et lesdites bornes (14, 15) sont disposées selon une figure circulaire au voisinage du pourtour de la carte.

4. Ensemble selon l'une quelconque des revendications précédentes, dans lequel ledit orifice (11) est circulaire et est situé au centre de la carte (10).

5. Ensemble selon l'une quelconque des revendications précédentes, dans lequel lesdits fils (17) sont réalisés en tungstène.

6. Ensemble selon l'une quelconque des revendications 1 à 4, dans lequel lesdits fils (17) sont réalisés en un alliage de cuivre.

7. Ensemble selon l'une quelconque des revendications précédentes, dans lequel ladite couche (18) est formée par moulage d'une résine époxy.

8. Ensemble selon l'une quelconque des revendications précédentes, dans lequel ledit anneau (16) est réalisé en aluminium anodisé.

9. Ensemble selon l'une quelconque des revendications 1 à 7, dans lequel ledit anneau (16) est réalisé en un matériau céramique.

Fig. 1.

Fig. 3.

Fig. 2.

0 127 295

Fig. 4.

Fig. 5.

2

Fig.6.

Fig.7.